# EUROPEAN PATENT APPLICATION

(11) **EP 4 811 966 A1**
(43) Date of publication of application: **23.09.2026**
(21) Application number: 25208658.2
(22) Date of filing: 14.10.2025
(51) Int. Cl.: H10F 10/165, H10F 71/00, H10F 77/30

(54) **SOLAR CELL**

(30) Priority: 17.03.2025 CN 202510314945
(71) Applicant: Jinko Solar (Haining) Co., Ltd., Haining City, Zhejiang 314415 (CN)
(72) Inventor: WEI, He, HAINING 314415 (CN); WU, Junli, HAINING 314415 (CN); ZHANG, Bike, HAINING 314415 (CN); JIN, Jingsheng, HAINING 314415 (CN)
(74) Representative: DREISS Patentanwälte PartG mbB

(57) **Abstract**

Provided is a solar cell, including: a silicon substrate containing antimony, wherein silicon substrate has a first surface; an antimony-containing tunneling oxide layer covering first surface; and a doped conductive layer covering, along a thickness direction of the solar cell, a surface of antimony-containing tunneling oxide layer away from silicon substrate, where doped conductive layer contains antimony. An antimony concentration of antimony-containing tunneling oxide layer is greater than an antimony concentration of silicon substrate, and the antimony concentration of silicon substrate is greater than an antimony concentration of doped conductive layer. Along the thickness direction of the solar cell, a first antimony-containing region is formed at a side of doped conductive layer adjacent to antimony-containing tunneling oxide layer, and an antimony concentration of first antimony-containing region is greater than an antimony concentration of rest region of the doped conductive layer. Such a configuration increases the conductivity of the antimony-containing tunneling oxide layer, reduces the series resistance of the solar cell, and improves the fill factor of the solar cell, thereby improving the photoelectric conversion efficiency of the solar cell.

## Description

### TECHNICAL FIELD

The present disclosure relates to the technical field of solar cell, and in particular, to a solar cell.

### BACKGROUND

Solar cell converts directly solar radiation energy to electrical energy. In order to suppress carrier recombination on a surface of a substrate of the solar cell, a tunneling oxide layer and a doped conductive layer are generally formed on the surface of the substrate to enhance passivation effect on the substrate.

In an existing solar cell, a doped conductive layer still suffers from poor conductivity, resulting in a relatively high series resistance of the solar cells, which affects photoelectric conversion efficiency of the solar cell.

### SUMMARY

In view of this, the present disclosure provides a solar cell to solve the problem of lower photoelectric conversion efficiency of the existing solar cell in the art.

Embodiments of the present disclosure provide a solar cell, including: a silicon substrate containing antimony, where the silicon substrate has a first surface; an antimony-containing tunneling oxide layer covering the first surface; and a doped conductive layer covering, along a thickness direction of the solar cell, a surface of the antimony-containing tunneling oxide layer away from the silicon substrate, where the doped conductive layer contains antimony. An antimony concentration of the antimony-containing tunneling oxide layer is greater than an antimony concentration of the silicon substrate, and the antimony concentration of the silicon substrate is greater than an antimony concentration of the doped conductive layer. Along the thickness direction of the solar cell, a first antimony-containing region is formed at a side of the doped conductive layer adjacent to the antimony-containing tunneling oxide layer, and an antimony concentration of the first antimony-containing region is greater than an antimony concentration of rest region of the doped conductive layer.

In one or more embodiments, along the thickness direction of the solar cell, the antimony concentration of the antimony-containing tunneling oxide layer gradually decreases in a direction away from the silicon substrate; and/or along the thickness direction of the solar cell, the antimony concentration of the first antimony-containing region gradually decreases in the direction away from the silicon substrate.

In one or more embodiments, the antimony concentration of the silicon substrate ranges from 2.0×10¹⁶ cm⁻³ to 8.0×10¹⁶ cm⁻³

In one or more embodiments, the antimony concentration of the antimony-containing tunneling oxide layer ranges from 1.0×10¹⁸ cm⁻³ to 2.0×10¹⁸ cm⁻³.

In one or more embodiments, the antimony concentration of the first antimony-containing region ranges from 1.0×10¹⁶ cm⁻³ to 1.0×10¹⁸ cm⁻³.

In one or more embodiments, a thickness of the first antimony-containing region ranges from 5 nm to 10 nm.

In one or more embodiments, along the thickness direction of the solar cell, a second antimony-containing region is formed at a side of the silicon substrate adjacent to the antimony-containing tunneling oxide layer; and along the thickness direction of the solar cell, an antimony concentration of the second antimony-containing region gradually increases in a direction towards the antimony-containing tunneling oxide layer.

In one or more embodiments, a thickness of the second antimony-containing region ranges from 5 nm to 10 nm.

In one or more embodiments, a thickness of the antimony-containing tunneling oxide layer ranges from 1 nm to 10 nm; and/or a thickness of the doped conductive layer ranges from 20 nm to 300 nm.

In one or more embodiments, the doped conductive layer further contains phosphorus, and a phosphorus concentration of the doped conductive layer ranges from 1.0×10²⁰ cm⁻³ to 1.0×10²¹ cm⁻³.

According to one or more embodiments of the present disclosure, firstly, when the antimony concentration of the antimony-containing tunneling oxide layer is greater than the antimony concentration of the silicon substrate, a concentration gradient is formed between the antimony-containing tunneling oxide layer and the silicon substrate, and antimony atoms effectively diffuse from the antimony-containing tunneling oxide layer into the silicon substrate, which increases free electron concentration of the silicon substrate, thereby improving carrier transport efficiency and facilitating increase of conductivity of the silicon substrate and the antimony-containing tunneling oxide layer. In addition, the higher antimony concentration at a side of the antimony-containing tunneling oxide layer is contribute to better passivate the interface between the antimony-containing tunneling oxide layer and the silicon substrate, where interface defect density of the first surface is reduced by filling dangling bonds and other defects. Secondly, when the antimony concentration of the doped conductive layer is lower than the antimony concentration of the silicon substrate and also lower than the antimony concentration of the antimony-containing tunneling oxide layer, on the one hand, the lower antimony concentration avoids carrier concentration saturation in the doped conductive layer due to excessive doping, and reduces scattering effect, thereby avoiding decrease of carrier mobility; On the other hand, the lower antimony concentration ensures good ohmic contact between the first electrode and the silicon substrate, while avoiding introduction of additional interface defects or dangling bonds due to excessively high antimony doping concentration, which is beneficial for reducing contact resistance between the first electrode and the silicon substrate, improving current transport capability, and reducing energy loss, while enhancing interface passivation of the solar cell, thereby facilitating improvement of long-term stability and durability of the solar cell. In addition, the antimony in the doped conductive layer is mainly obtained by diffusion from the antimony-containing tunneling oxide layer into the doped conductive layer. Since the antimony-containing tunneling oxide layer has a certain blocking effect on antimony, it requires a more complex doping process if the antimony concentration of the doped conductive layer is set higher. Therefore, when the antimony concentration of the doped conductive layer is lower than the antimony concentration of the silicon substrate and also lower than the antimony concentration of the antimony-containing tunneling oxide layer, it is beneficial for reducing difficulty of doping process and saving doping material, thereby being beneficial for reducing production cost and production difficulty of the solar cell and improving the production efficiency of the solar cell. In addition, along the thickness direction of the solar cell, a first antimony-containing region is formed at a side of the doped conductive layer adjacent to the antimony-containing tunneling oxide layer, and an antimony concentration of the first antimony-containing region is greater than an antimony concentration of rest region of the doped conductive layer. By such concentration setting, the antimony is concentrated at the side of the doped conductive layer adjacent to the antimony-containing tunneling oxide layer. That is, a relatively higher antimony concentration is maintained at the side of the doped conductive layer adjacent to the first surface, thereby being beneficial for improving passivation effect on the first surface by the doped conductive layer.

It may be understood that the general description above and the detailed description in the following are merely illustrative, and cannot limit the present disclosure.

### BRIEF DESCRIPTION OF DRAWINGS

In order to more clearly illustrate the technical solutions in embodiments of the present disclosure, the drawings, which are intended to be used in the description of embodiments, are briefly described as below.
FIG. 1 is a schematic diagram of a sectional structure of a solar cell according to one or more embodiments of the present disclosure;
FIG. 2 is an antimony curve graph of obtained by Secondary Ion Mass Spectrometry (SIMS) measurement of the solar cell shown in FIG. 1; and
FIG. 3 is an enlarged view of a part A shown in FIG. 1.

### Reference signs:

1 - silicon substrate;
   1a - first surface;
   1b - second surface;
   11 - second antimony-containing region;
2 - antimony-containing tunneling oxide layer;
3 - doped conductive layer;
   31 - first antimony-containing region;
4 - first electrode;
5 - first passivation layer;
6 - emitter;
7 - second electrode;
8 - second passivation layer.

### DESCRIPTION OF EMBODIMENTS

In order to better understand the technical solutions of the present disclosure, embodiments of the present disclosure are described in detail below in conjunction with the drawings.

It is to be made clear that the described embodiments are only some rather than all of the embodiments of the present disclosure.

The terms used in embodiments of the present disclosure are for the purpose of describing specific embodiments only, and are not intended to limit the present disclosure. As used in embodiments of the present disclosure and the appended claims, the singular forms "a/an", "said", and "the" are intended to include the plural forms as well, unless the context clearly indicated otherwise.

It may be understood that the term "and/or" used herein is merely an association relationship describing an associated object, and indicates that there may be three relationships. For example, A and/or B, and may indicate: only A, both A and B, and only B. In addition, the character "/" herein generally indicates that the related objects before and after the character present an "or" relationship.

Embodiments of the present disclosure provide a solar cell. The solar cell includes a silicon substrate 1. The silicon substrate 1 is configured to receive sunlight and generate photogenerated carriers. The silicon substrate 1 is specifically a monocrystalline silicon substrate, a polycrystalline silicon substrate, a microcrystalline silicon substrate, a nanocrystalline silicon substrate, etc. In some embodiments of the present disclosure, the silicon substrate 1 is an N-type silicon substrate doped with antimony (Sb), in which antimony atoms replace some silicon atoms in a silicon lattice. Since an antimony atom has five valence electrons, whereas a silicon atom has only four valence electrons, each antimony atom provides one additional free electron to the lattice. The free electrons provided by the antimony atoms increase the carrier concentration, which reduce the resistivity of the silicon substrate 1, and improve the conductivity of the silicon substrate 1, thereby improving the electrical conductivity of the silicon substrate 1. In some embodiments, the silicon substrate 1 employs only antimony as the doping element. Alternatively, the silicon substrate 1, in addition to antimony, is also doped with one or more Group V elements, such as nitrogen (N), phosphorus (P), arsenic (As), bismuth (Bi), etc. That is, the silicon substrate 1 is an N-type silicon substrate doped solely with antimony, or an N-type silicon substrate co-doped with antimony and other Group V element. In some embodiments of the present disclosure, the silicon substrate 1 is described by way of example as an N-type silicon substrate co-doped with phosphorus and antimony.

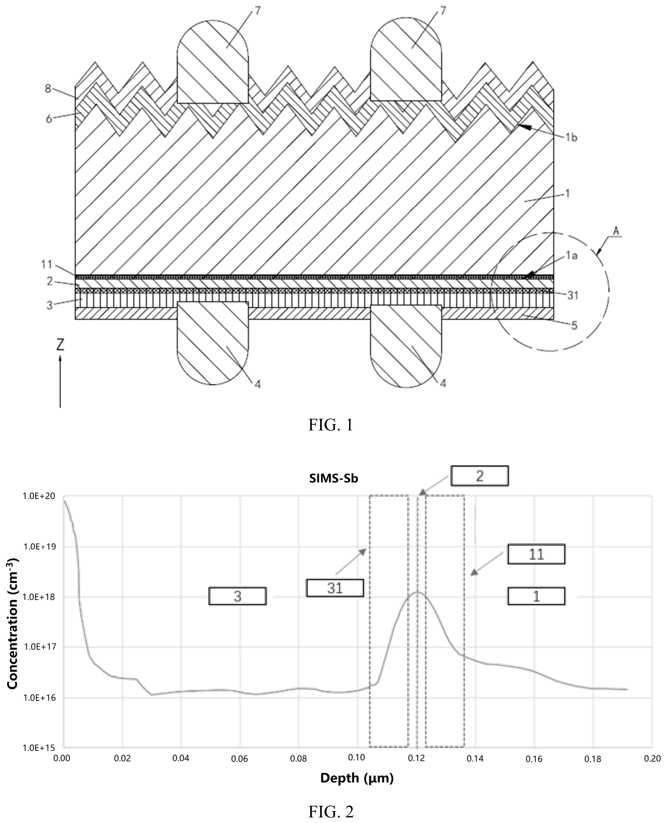

As shown in FIG. 1, the silicon substrate 1 has a first surface 1a and a second surface 1b that are arranged opposite to each other along the thickness direction Z of the solar cell. The first surface 1a is a backlight surface of the silicon substrate 1, i.e., the surface of the silicon substrate 1 facing away from the light source and configured to receive ground-reflected sunlight. The second surface 1b is a light-facing surface of the silicon substrate 1, i.e., the surface of the silicon substrate 1 facing toward the light source and configured to receive direct sunlight. That is, both the first surface 1a and the second surface 1b absorb sunlight, allowing the conversion of light energy into electrical energy by the solar cell.

The solar cell further includes an antimony-containing tunneling oxide layer 2 and a doped conductive layer 3. The antimony-containing tunneling oxide layer 2 covers the first surface 1a. Along the thickness direction Z of the solar cell, the doped conductive layer 3 covers a surface of the antimony-containing tunneling oxide layer 2 away from the silicon substrate 1. The antimony-containing tunneling oxide layer 2 and the doped conductive layer 3 that are stacked form a passivated contact structure, which improves the efficiency of electron collection by the doped conductive layer 3.

In some embodiments, the antimony-containing tunneling oxide layer 2 includes at least one of silicon oxide, aluminum oxide, silicon nitride, silicon oxynitride, silicon carbide, magnesium fluoride, amorphous silicon, and polycrystalline silicon. The lattice of the antimony-containing tunneling oxide layer 2 is well matched with the lattice of the silicon substrate 1, so as to chemically passivate the first surface 1a to reduce the interface defect density of the first surface 1a, thereby reducing the recombination centers of the first surface 1a to lower the carrier recombination rate. In some embodiments of the present disclosure, since the antimony-containing tunneling oxide layer 2 is enriched with antimony, on the one hand, the antimony atoms increase the free electron concentration of the antimony-containing tunneling oxide layer 2, which is beneficial for improving the conductivity of the antimony-containing tunneling oxide layer 2, and also realizes the adjustment of the energy band structure, allowing electrons to pass through the antimony-containing tunneling oxide layer 2 more easily, thereby reducing the energy loss during tunneling. On the other hand, antimony atoms effectively fill the defect sites in the silicon lattice, thereby reducing the number of dangling bonds and lowering the interface defect density of the first surface 1a.

In addition, in the related art, a hydrogen passivation technology is generally used to address defect problems in the solar cell. However, due to the limitations of hydrogen injection technology, the concentration of hydrogen atoms injected into the solar cell is generally lower than the defect concentration. Especially when a large number of defects are present, the number of hydrogen atoms is insufficient to fully passivate all defects. In some embodiments of the present disclosure, the antimony atoms effectively passivate some deep defects or high-density defect regions that are difficult be treated by hydrogen passivation to a certain extent. In addition, the antimony atoms form stable and unbreakable covalent bonds with surrounding silicon atoms, which is beneficial for maintaining good passivation effect. That is, by providing the antimony-containing tunneling oxide layer 2, not only the passivation effect of the solar cell is improved, thereby enhancing the photoelectric conversion efficiency of the solar cell, but also it is beneficial for reducing the process requirements of the subsequent hydrogen injection technology, and lowering the resource consumption, thereby reducing the production difficulty and production cost of the solar cell.

The doped conductive layer 3 is configured to form a field passivation layer, which reduces the concentration of minority carriers (holes) and realizes the selective transmission of majority carriers (free electrons), reducing the recombination rate of the carriers, improving the voltage of the solar cell, and increasing the short-circuit current of the solar cell, thereby improving the photoelectric conversion efficiency of the solar cell. The doped conductive layer 3 contains antimony, antimony enhances the long-term stability of the doped conductive layer 3, which is beneficial for improving the reliability of the solar cell to prolong the service life of the solar cell. In some embodiments, the doped conductive layer 3 has a structure doped solely with antimony, or a structure doped with antimony and other Group V element, where the Group V element is nitrogen (N), phosphorus (P), arsenic (As), bismuth (Bi), etc.

As shown in FIG. 1, the solar cell further includes a first electrode 4 and a first passivation layer 5. Along the thickness direction Z of the solar cell, a plurality of first electrodes 4 are arranged at a side of the doped conductive layer 3 away from the antimony-containing tunneling oxide layer 2. The plurality of first electrodes 4 are respectively electrically connected to the doped conductive layer 3. The first passivation layer 5 covers the surface of the doped conductive layer 3 away from the antimony-containing tunneling oxide layer 2. A composition of the first passivation layer 5 includes one or more of silicon oxide, silicon nitride, titanium oxide, aluminum oxide, or silicon oxynitride. The first passivation layer 5 has a single-layer structure, or a multi-layer structure, and the refractive index and the thickness of each layer are correspondingly designed. The first passivation layer 5 plays a role in passivating the surface in contact therewith, for enhancing the passivation effect of the solar cell, which reduces the recombination of carriers at the interface and improves the transport efficiency of carriers, thereby improving the photoelectric conversion efficiency of the solar cell. The first passivation layer 5 also has functions of reducing or eliminating the reflection effect of the first surface 1a and increasing the light transmittance of the second surface 1b, which is beneficial for further improving the photoelectric conversion efficiency of the solar cell.

The first electrode 4 specifically serves as a negative electrode of the solar cell. At least part structure of the first electrode 4 penetrates through the doped conductive layer 3 and forms electrical connection with the antimony-containing tunneling oxide layer 2. The antimony-containing tunneling oxide layer 2 improves the conductivity and ensures good ohmic contact formed between the first electrode 4 and the silicon substrate 1, facilitating reduction of the series resistance of the solar cells, and thereby facilitating improvement of the photoelectric conversion efficiency of the solar cell.

As shown in FIGS. 1 and 2, in some embodiments of the present disclosure, the antimony concentration of the antimony-containing tunneling oxide layer 2 is greater than the antimony concentration of the silicon substrate 1, and the antimony concentration of the silicon substrate 1 is greater than the antimony concentration of the doped conductive layer 3. Firstly, when the antimony concentration of the antimony-containing tunneling oxide layer 2 is greater than the antimony concentration of the silicon substrate 1, a concentration gradient is formed between the antimony-containing tunneling oxide layer 2 and the silicon substrate 1, and antimony atoms effectively diffuse from the antimony-containing tunneling oxide layer 2 into the silicon substrate 1, which increases free electron concentration of the silicon substrate 1, thereby improving carrier transport efficiency and facilitating increase of conductivity of the silicon substrate 1 and the antimony-containing tunneling oxide layer 2. In addition, the higher antimony concentration at a side of the antimony-containing tunneling oxide layer 2 is contribute to better passivate the interface between the antimony-containing tunneling oxide layer 2 and the silicon substrate 1, where interface defect density of the first surface 1a is reduced by filling dangling bonds and other defects.

Secondly, when the antimony concentration of the doped conductive layer 3 is lower than the antimony concentration of the silicon substrate 1 and also lower than the antimony concentration of the antimony-containing tunneling oxide layer 2, on the one hand, the lower antimony concentration avoids carrier concentration saturation in the doped conductive layer 3 due to excessive doping, and reduces scattering effect, thereby avoiding decrease of carrier mobility; On the other hand, the lower antimony concentration ensures good ohmic contact between the first electrode 4 and the silicon substrate 1, while avoiding introduction of additional interface defects or dangling bonds due to excessively high antimony doping concentration, which is beneficial for reducing contact resistance between the first electrode 4 and the silicon substrate 1, improving current transport capability, and reducing energy loss, while enhancing interface passivation of the solar cell, thereby facilitating improvement of long-term stability and durability of the solar cell. In addition, the antimony in the doped conductive layer 3 is mainly obtained by diffusion from the antimony-containing tunneling oxide layer 2 into the doped conductive layer 3. Since the antimony-containing tunneling oxide layer 2 has a certain blocking effect on antimony, it requires a more complex doping process if the antimony concentration of the doped conductive layer 3 is set higher. Therefore, when the antimony concentration of the doped conductive layer 3 is lower than the antimony concentration of the silicon substrate 1 and also lower than the antimony concentration of the antimony-containing tunneling oxide layer 2, it is beneficial for reducing difficulty of doping process and saving doping material, thereby being beneficial for reducing production cost and production difficulty of the solar cell and improving production efficiency of the solar cell.

Therefore, according to the solar cell provided by some embodiments of the present disclosure, the silicon substrate 1, the antimony-containing tunneling oxide layer 2, and the doped conductive layer 3 are doped with antimony respectively. In addition, the antimony concentration of the antimony-containing tunneling oxide layer 2 is set to be greater than the antimony concentration of the silicon substrate 1, and the antimony concentration of the silicon substrate 1 is set to be greater than the antimony concentration of the doped conductive layer 3, which increases the conductivity of the antimony-containing tunneling oxide layer 2, reduces the series resistance of the solar cells, and improves the fill factor of the solar cell, thereby improving the photoelectric conversion efficiency of the solar cell.

In addition, as shown in FIGS. 1 and 2, along the thickness direction Z of the solar cell, a first antimony-containing region 31 is formed at a side of the doped conductive layer 3adjacent to the antimony-containing tunneling oxide layer 2, and an antimony concentration of the first antimony-containing region 31 is greater than an antimony concentration of rest region of the doped conductive layer 3. By such concentration setting, the antimony is concentrated at the side of the doped conductive layer 3 adjacent to the antimony-containing tunneling oxide layer 2. That is, a relatively higher antimony concentration is maintained at the side of the doped conductive layer 3 adjacent to the first surface 1a, thereby being beneficial for improving passivation effect on the first surface 1a by the doped conductive layer 3.

It may be noted that each antimony concentrations of the silicon substrate 1, the antimony-containing tunneling oxide layer 2, the doped conductive layer 3, and the first antimony-containing region 31 is detected by a method, such as Secondary Ion Mass Spectrometry (SIMS), Inductively Coupled Plasma Mass Spectrometry (ICP-MS), Glow Discharge Mass Spectrometry (GDMS), etc. The detection method of SIMS is preferred in some embodiments of the present disclosure. The antimony concentration of the silicon substrate 1 refers to an average antimony concentration at each points in the silicon substrate 1. The antimony concentration of the antimony-containing tunneling oxide layer 2 refers to an average antimony concentration at each points in the antimony-containing tunneling oxide layer 2. The antimony concentration of the doped conductive layer 3 refers to an average antimony concentration at each points in the doped conductive layer 3. The antimony concentration of the first antimony-containing region 31 refers to an average antimony concentration at each points in the first antimony-containing region 31.

The silicon substrate 1, the antimony-containing tunneling oxide layer 2, and the doped conductive layer 3 are described in detail below.

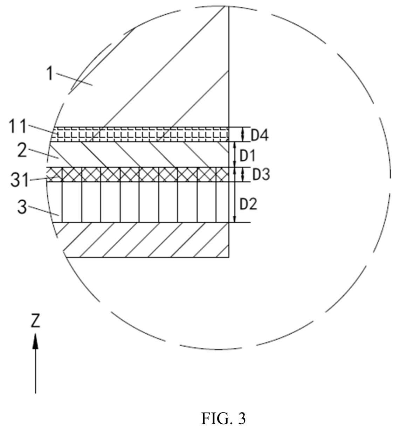

As shown in FIG. 3, in one or more embodiments, a thickness D1 of the antimony-containing tunneling oxide layer 2 ranges from 1 nm to 10 nm. D1 may specifically be 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, or 10 nm, or other values in the above range, which is not limited herein.

In some embodiments, if D1 is too small (for example, less than 1 nm), the antimony-containing tunneling oxide layer 2 does not provide sufficient passivation, resulting in an increase in the interface defect density on the first surface 1a. If D1 is too large (for example, greater than 10 nm), the resistance of the antimony-containing tunneling oxide layer 2 increases, and carriers are difficult to effectively pass through the antimony-containing tunneling oxide layer 2, resulting in a decrease in tunneling efficiency of the carriers, thereby increasing the series resistance of the solar cell to affect the photoelectric conversion efficiency of the solar cell. Therefore, when D1 ranges from 1 nm to 10 nm, it ensures that the antimony-containing tunneling oxide layer 2 not only provides effective passivation on the first surface 1a, but also maintains a lower resistance, thereby achieving efficient carrier transport, and facilitating improvement of the photoelectric conversion efficiency of the solar cell.

In one or more embodiments, as shown in FIG. 2, the antimony concentration of the antimony-containing tunneling oxide layer 2 ranges from 1.0×10¹⁸ cm⁻³ to 2.0×10¹⁸ cm⁻³, which may specifically be 1.0×10¹⁸ cm⁻³, 1.1×10¹⁸ cm⁻³, 1.2×10¹⁸ cm⁻³, 1.3×10¹⁸ cm⁻³, 1.4×10¹⁸ cm⁻³, 1.5×10¹⁸ cm⁻³, 1.6×10¹⁸ cm⁻³, 1.7×10¹⁸ cm⁻³, 1.8×10¹⁸ cm⁻³, 1.9×10¹⁸ cm⁻³, or 2.0×10¹⁸ cm⁻³, or other values in the above range, which is not limited herein.

If the antimony concentration is too low (for example, lower than 1.0×10¹⁸ cm⁻³), the antimony-containing tunneling oxide layer 2 does not provide sufficient passivation, resulting in an increase in the interface defect density of the first surface 1a, and failing to ensure good ohmic contact between the first electrode 4 and the silicon substrate 1, thereby increasing the series resistance of the solar cell. If the antimony concentration is too high (for example, higher than 2.0×10¹⁸ cm⁻³), more additional interface defects or dangling bonds are introduced, affecting the carrier mobility and increasing the resistance of the antimony-containing tunneling oxide layer 2. Therefore, when the antimony concentration gradient of the antimony-containing tunneling oxide layer 2 satisfies the above range, the optimal passivation and carrier transport efficiency are achieved without affecting other performances and indicators of the solar cell, thereby facilitating improvement of the photoelectric conversion efficiency and the long-term stability of the solar cell, and facilitating improvement of the service life of the solar cell. In addition, a proper antimony concentration helps to tune the energy band structure of the antimony-containing tunneling oxide layer 2, forming a favorable barrier height and shape, and promoting the effective separation and transport of electrons and holes.

In one or more embodiments, along the thickness direction Z of the solar cell, the antimony concentration of the antimony-containing tunneling oxide layer 2 gradually decreases in a direction away from the silicon substrate 1. That is, the distribution of antimony in the antimony-containing tunneling oxide layer 2 exhibits a concentration gradient variation. In these embodiments, a relatively higher antimony concentration is maintained at the side of the antimony-containing tunneling oxide layer 2 adjacent to the silicon substrate 1, which effectively fill defects and dangling bonds in the silicon lattice, reducing the interface defect density on the first surface 1a, and facilitating improvement of the passivation on the first surface 1a, thereby maintaining good interface quality. In addition, the antimony concentration decreases gradually as the distance from the silicon substrate 1 increases, which reduces the possibility of the introduction of new defects or impurity scattering centers, and facilitates improvement of the carrier mobility. Therefore, by setting a proper antimony concentration gradient, the antimony-containing tunneling oxide layer 2 helps to reduce the defect density on the first surface 1a, increasing the open-circuit voltage of the solar cell, thereby improving the overall performance of the solar cell.

As shown in FIG. 3, in one or more embodiments, the thickness D2 of the doped conductive layer 3 ranges from 20 nm to 300 nm. D2 may specifically be 20 nm, 50 nm, 60 nm, 80 nm, 100 nm, 110 nm, 130 nm, 150 nm, 170 nm, 190 nm, 200 nm, 220 nm, 240 nm, 250 nm, 260 nm, 280 nm, or 300 nm, or other values in the above range, which is not limited herein.

In these embodiments, if D2 is too small (for example, less than 20 nm), there is a thin-layer effect, resulting in an increase in the resistance of the doped conductive layer 3 to affect the carrier transport efficiency. If D2 is too large (for example, greater than 300 nm), there is a problem of uneven doping, resulting in an increase in the local resistance of the doped conductive layer 3, and even forming a defect, which affects the carrier transport efficiency and increases the energy loss during the carrier transport. Therefore, when D2 ranges from 20 nm to 300 nm, it facilitates improvement of the carrier mobility, thereby improving the conversion efficiency of the solar cell. In addition, when D2 ranges from 20 nm to 300 nm, the doped conductive layer 3 remains within a proper thickness range, reducing the light absorption capability of the doped conductive layer 3, thereby reducing the optical loss of the solar cell to improve the photoelectric conversion efficiency of the solar cell.

In one or more embodiments, the thickness D3 of the first antimony-containing region 31 ranges from 5 nm to 10 nm. D3 may specifically be 5 nm, 5.5 nm, 6 nm, 6.5 nm, 7 nm, 7.5 nm, 8 nm, 8.5 nm, 9 nm, 9.5 nm, or 10 nm, or other values in the above range, which is not limited herein.

In these embodiments, since the antimony in the doped conductive layer 3 is diffused from the antimony-containing tunneling oxide layer 2, the thickness D3 of the formed first antimony-containing region 31 generally does not exceed 10 nm due to the limitations of diffusion effect and production cost of the diffusion process. In addition, if D3 is too large (for example, greater than 10 nm), there is a problem of uneven doping, resulting in an increase in the local resistance of the first antimony-containing region 31, which affects the carrier transport efficiency and increases the energy loss during the carrier transport. If D3 is too small (for example, less than 5 nm), the passivation ability of the doped conductive layer 3 is affected, resulting in an increase in the interface defect density on the first surface 1a and in a shortened carrier lifetime, thereby affecting the overall performance of the solar cell. In addition, the excessively thin first antimony-containing region 31 is more sensitive to the external environment (such as moisture, oxygen, etc.), and is prone to be easily affected by corrosion or other chemical reactions. Under the environment of high-temperature or high-stress, it is also prone to material degradation or peeling, affecting the service life of the solar cell. Therefore, when D3 ranges from 5 nm to 10 nm, it not only ensures that the first antimony-containing region 31 provides good passivation and electrical performance for the solar cell, but also properly reduces the process difficulty and the production cost of the solar cell.

In one or more embodiments, as shown in FIG. 2, the antimony concentration of the first antimony-containing region 31 ranges from 1.0×10¹⁶ cm⁻³ to 1.0×10¹⁸ cm⁻³, which may specifically be 1.0×10¹⁶ cm⁻³, 2.0×10¹⁶ cm⁻³, 5.0×10¹⁶ cm⁻³, 8.0×10¹⁶ cm⁻³, 1.0×10¹⁷ cm⁻³, 2.0×10¹⁷ cm⁻³, 5.0×10¹⁷ cm⁻³, 7.0×10¹⁷ cm⁻³, 9.0×10¹⁷ cm⁻³, or 1.0×10¹⁸ cm⁻³, or other values in the above range, which is not limited herein.

If the antimony concentration is too low (for example, lower than 1.0×10¹⁶ cm⁻³), the passivation ability of the doped conductive layer 3 is affected, resulting in an increase in the interface defect density on the first surface 1a. If the antimony concentration is too high (for example, higher than 1.0×10¹⁸ cm⁻³), more additional interface defects or dangling bonds are introduced, affecting the carrier mobility. The excessively high antimony concentration causes a decrease in the chemical stability of the solar cell, affecting the service life of the solar cell. Therefore, when the antimony concentration gradient of the doped conductive layer 3 satisfies the above range, the passivation ability of the doped conductive layer 3 is ensured, thereby improving the photoelectric conversion efficiency, the long-term stability, and the service life of the solar cell.

In these embodiments, the doped conductive layer 3 also contains antimony in rest region other than the first antimony-containing region 31, while the antimony concentration thereof is lower than the antimony concentration of the first antimony-containing region 31. An antimony concentration of the rest region of the doped conductive layer 3 other than the first antimony-containing region 31 ranges from 1.0×10¹⁶ cm⁻³ to 2.0×10¹⁶ cm⁻³, which may specifically be 1.0×10¹⁶ cm⁻³, 1.1×10¹⁶ cm⁻³, 1.2×10¹⁶ cm⁻³, 1.3×10¹⁶ cm⁻³, 1.4×10¹⁶ cm⁻³, 1.5×10¹⁶ cm⁻³, 1.6×10¹⁶ cm⁻³, 1.7×10¹⁶ cm⁻³, 1.8×10¹⁶ cm⁻³, 1.9×10¹⁶ cm⁻³, or 2.0×10¹⁶ cm⁻³.

If the antimony concentration is too low (for example, lower than 1.0×10¹⁶ cm⁻³), the passivation ability of the doped conductive layer 3 is affected, resulting in an increase in the interface defect density on the first surface 1a. If the antimony concentration is too high (for example, higher than 2.0×10¹⁶ cm⁻³), the process difficulty and the production cost of the solar cell are increased.

In one or more embodiments, along the thickness direction Z of the solar cell, the antimony concentration of the first antimony-containing region 31 gradually decreases in a direction away from the silicon substrate 1. That is, the distribution of antimony in the first antimony-containing region 31 exhibits a concentration gradient variation. In these embodiments, a relatively higher antimony concentration is maintained at the side of the first antimony-containing region 31 adjacent to the antimony-containing tunneling oxide layer 2, which facilitates improvement of the passivation of the first antimony-containing region 31. In addition, the antimony concentration decreases gradually as the distance from the silicon substrate 1 increases, which reduces the possibility of the introduction of new defects or impurity scattering centers, and facilitates improvement of the carrier mobility. Therefore, by setting a proper antimony concentration gradient, the first antimony-containing region 31 helps to reduce the defect density on the first surface 1a, increasing the open-circuit voltage of the solar cell, thereby improving the overall performance of the solar cell.

In one or more embodiments, the antimony concentration of the silicon substrate 1 ranges from 2.0×10¹⁶ cm⁻³ to 8.0×10¹⁶ cm⁻³, which may specifically be 2.0×10¹⁶ cm⁻³, 2.5×10¹⁶ cm⁻³, 3.0×10¹⁶ cm⁻³, 3.5×10¹⁶ cm⁻³, 4.0×10¹⁶ cm⁻³ 4.5×10¹⁶ cm⁻³, 5.0×10¹⁶ cm⁻³, 5.5×10¹⁶ cm⁻³, 6.0×10¹⁶ cm⁻³, 6.5×10¹⁶ cm⁻³, 10×10¹⁶ cm⁻³, 7.5×10¹⁶ cm⁻³, or 8.0×10¹⁶ cm⁻³, or other values in the above range, which is not limited herein.

If the antimony concentration is too low (for example, lower than 2.0×10¹⁶ cm⁻³), there are insufficient free electrons in the silicon substrate 1, resulting in an increase in the electrical conductivity of the silicon substrate 1, limiting the current transport efficiency. If the antimony concentration is too high (for example, higher than 8.0×10¹⁶ cm⁻³), there are more defects introduced, affecting the photoelectric conversion efficiency of the solar cell, and resulting in a decrease in the chemical stability of the silicon substrate 1, which causes the diffusion of antimony atoms at high-temperature to lead to the structure changes or the formation of new defects of the silicon substrate 1, thereby affecting the service life and the long-term stability of the solar cell. Therefore, when the antimony concentration gradient of the silicon substrate 1 satisfies the above range, the photoelectric conversion efficiency of the solar cell is improved without affecting the stability and the service life of the solar cell.

Further, along the thickness direction Z of the solar cell, a second antimony-containing region 11 with a relatively high antimony concentration is formed at a side of the silicon substrate 1 adjacent to the antimony-containing tunneling oxide layer 2. A thickness D4 of the second antimony-containing region 11 ranges from 5 nm to 10 nm. D4 may specifically be 5 nm, 5.5 nm, 6 nm, 6.5 nm, 7 nm, 7.5 nm, 8 nm, 8.5 nm, 9 nm, 9.5 nm, or 10 nm, or other values in the above range, which is not limited herein.

In these embodiments, the second antimony-containing region 11 with a relatively high antimony concentration is arranged at a side of the silicon substrate 1 adjacent to the first surface 1a, which effectively fill dangling bonds and other defects in the silicon lattice, reducing the interface defect density on the first surface 1a, thereby facilitating improvement of the passivation on the first surface 1a. In addition, it also facilitates the diffusion of antimony in the second antimony-containing region 11 to the antimony-containing tunneling oxide layer 2, thereby reducing the process difficulty of preparing the antimony-containing tunneling oxide layer 2. If D4 is too small (for example, less than 5 nm), there are insufficient free carriers for meeting the requirements of efficient current transport, and there is a problem of local uneven doping in the second antimony-containing region 11, affecting the photoelectric conversion efficiency of the solar cell. If D4 is too large (for example, greater than 10 nm), there are new interface defects introduced, destroying the passivation on the first surface 1a, and increasing the resistance of the second antimony-containing region 11, thereby resulting in an increase in the energy loss during carrier transport. Therefore, when D4 ranges from 5 nm to 10 nm, it is beneficial for improving the electrical performance of the solar cell.

In one or more embodiments, along the thickness direction Z of the solar cell, the antimony concentration of the second antimony-containing region 11 gradually increases in a direction towards the antimony-containing tunneling oxide layer 2. That is, the distribution of antimony in the second antimony-containing region 11 exhibits a concentration gradient variation. In these embodiments, the higher antimony concentration at the side of the second antimony-containing region 11 adjacent to the antimony-containing tunneling oxide layer 2 provides more free electrons, which effectively fills the defect sites in the silicon lattice and reduces the amount of dangling bonds, so as to further reduce the interface defect density of the first surface 1a. The lower antimony concentration at the side of the second antimony-containing region 11 away from the antimony-containing tunneling oxide layer 2 is beneficial for reducing the resistivity of the silicon substrate 1 and improving the conductivity of the silicon substrate 1, thereby improving the electrical conductivity of the silicon substrate 1.

In some embodiments of the present disclosure, the doping element in the silicon substrate 1 is phosphorus and antimony for co-doping. Phosphorus is a high-efficiency shallow-level dopant that is easily activated at low-temperature to provide a large amount of free carriers. While, antimony has a higher activation energy and is generally fully activated at a relatively high temperature. By combining these two doping elements, the silicon substrate 1 maintains a high free carrier concentration in different temperature ranges and a stable electrical performance in a wide temperature range. Phosphorus-doping provides more free carriers, and antimony-doping helps to reduce impurity scattering. Such a combination better balances carrier concentration and mobility, thereby improving the overall electrical performance. Therefore, the co-doping of phosphorus and antimony better balances the carrier concentration and the mobility in the silicon substrate 1 to improve the overall electrical performance of the solar cell.

In one or more embodiments, the phosphorus concentration of the silicon substrate 1 ranges from 1.804×10¹⁵ cm⁻³ to 4.798×10¹⁶cm⁻³, which may specifically be 1.804×10¹⁵ cm⁻³, 2.0×10¹⁵ cm⁻³, 3.0×10¹⁵ cm⁻³, 4.0×10¹⁵ cm⁻³, 5.0×10¹⁵ cm⁻³, 6.0×10¹⁵ cm⁻³, 7.0×10¹⁵ cm⁻³, 8.0×10¹⁵ cm⁻³, 9.0×10¹⁵ cm⁻³, 1.0×10¹⁶ cm⁻³, 2.0×10¹⁶ cm⁻³, 3.0×10¹⁶ cm⁻³, 4.0×10¹⁶ cm⁻³, or 4.798×10¹⁶cm⁻³, or other values in the above range, which is not limited herein.

If the phosphorus concentration is too low (for example, lower than 1.804×10¹⁵ cm⁻³), there are insufficient free electrons in the silicon substrate 1, resulting in an increase in the electrical conductivity of the silicon substrate 1, limiting the current transport efficiency, and affecting the photoelectric conversion efficiency of the solar cell. If the phosphorus concentration is too high (for example, higher than 4.798×10¹⁶cm⁻³), there are more defects introduced, affecting the carrier mobility. Therefore, when the phosphorus concentration gradient of the silicon substrate 1 satisfies the above range, the photoelectric conversion efficiency of the solar cell is improved.

In some embodiments of the present disclosure, the doped conductive layer 3 is also doped with phosphorus. That is, the doped element in the doped conductive layer 3 is phosphorus and antimony for co-doping. Phosphorus is a high-efficiency shallow-level dopant that is easily activated at low-temperature to provide a large amount of free carriers. While, antimony has a higher activation energy and is generally fully activated at a relatively high temperature. By combining these two doping elements, the doped conductive layer 3 maintains a high free carrier concentration in different temperature ranges and a stable electrical performance in a wide temperature range. If a single dopant with high concentration alone (such as phosphorus or antimony) is employed, excessive defects are introduced, which reduces the carrier mobility. In some embodiments of the present disclosure, co-doping phosphorus and antimony increases carrier concentration without significantly increasing defects, thereby optimizing the carrier mobility. Phosphorus-doping provides more free carriers, and antimony-doping helps to reduce impurity scattering. Such a combination better balances the carrier concentration and the mobility in the doped conductive layer 3 to improve the overall electrical performance of the solar cell.

In one or more embodiments, the phosphorus concentration of the doped conductive layer 3 ranges from 1.0×10²⁰ cm⁻³ to 1.0×10²¹ cm⁻³, which may specifically be 1.0×10²⁰ cm⁻³, 2.0×10²⁰ cm⁻³, 3.0×10²⁰ cm⁻³, 4.0×10²⁰ cm⁻³, 5.0×10²⁰ cm⁻³, 6.0×10²⁰ cm⁻³, 7.0×10²⁰ cm⁻³, 8.0×10²⁰ cm⁻³, 9.0×10²⁰ cm⁻³, or 1.0×10²¹ cm⁻³, or other values in the above range, which is not limited herein.

If the phosphorus concentration is too low (for example, lower than 1.0×10²⁰ cm⁻³), there are insufficient free electrons in the doped conductive layer 3, resulting in an increase in the electrical conductivity of the doped conductive layer 3, limiting the current transport, and affecting the photoelectric conversion efficiency of the solar cell. If the phosphorus concentration is too high (for example, higher than 1.0×10²¹ cm⁻³), there are more defects introduced, affecting the carrier mobility. Therefore, when the phosphorus concentration gradient of the doped conductive layer 3 satisfies the above range, the photoelectric conversion efficiency of the solar cell is improved.

In some embodiments of the present disclosure, the phosphorus concentration of the doped conductive layer 3 is greater than the phosphorus concentration of the silicon substrate 1. The doped conductive layer 3 with a high phosphorus-doping concentration generate large energy band bending at the first surface 1a, which facilitates blocking minority carriers and promoting the transport of majority carriers, thereby improving the electrical performance of the solar cell.

In some embodiments of the present disclosure, a method of preparing the antimony-containing tunneling oxide layer 2 is one of wet oxidation, thermal oxidation, plasma-enhanced chemical vapor deposition (PECVD) ionization, and ozone oxidation, or a combination thereof. In some embodiments, the antimony concentration of the antimony-containing tunneling oxide layer 2 is controlled by changing the preparation temperature or time during preparing the antimony-containing tunneling oxide layer 2, or by changing the doping ratio of antimony in the silicon substrate 1.

In one or more embodiments, a method of preparing the solar cell is as follows: preparing a silicon wafer as the silicon substrate 1 for texturing treatment, front boron-doping treatment, and back cleaning treatment, preparing a tunneling oxide layer and an intrinsic amorphous silicon layer at the back surface (the first surface 1a) of the silicon wafer by using a low pressure chemical vapor deposition (LPCVD) process, and conducting a phosphorus diffusion process. During the phosphorus diffusion process, the antimony in the silicon substrate 1 is diffused outward from the silicon substrate 1 into the tunneling oxide layer and the intrinsic amorphous silicon layer under the driving force of high-temperature, allowing the tunneling oxide layer to form the antimony-containing tunneling oxide layer 2, and the intrinsic amorphous silicon layer to form the doped conductive layer 3.

In some embodiments, for depositing the tunneling oxide layer, the deposition temperature ranges from 400°C to 700°C, which may specifically be 400°C, 450°C, 500°C, 550°C, 600°C, 650°C, or 700°C, and the treatment time ranges from 400 s to 700 s, which may specifically be 400 s, 450 s, 500 s, 550 s, 600 s, 650 s, or 700 s, with oxygen and water vapor introduced. For depositing the intrinsic amorphous silicon layer, the deposition temperature ranges from 400°C to700 °C, which may specifically be 400°C, 450°C, 500°C, 550°C, 600°C, 650°C, or 700°C, and the treatment time ranges from 1000 s to 2000 s, which may specifically be 1000 s, 1100 s, 1200 s, 1300 s, 1400 s, 1500 s, 1600 s, 1700 s, 1800 s, 1900 s, or 2000 s, with a silicon source gas (such as silane) introduced.

In some embodiments of the present disclosure, during the process of preparing the tunneling oxide layer, the antimony diffuses into the tunneling oxide layer to form the antimony-containing tunneling oxide layer 2, in which the antimony mainly occupies vacancies in the oxide layer to form more stable chemical bonds, thereby achieving better interface passivation of the first surface 1a. By adopting the above preparation method, on one hand, the diffusion depth of phosphorus atoms in the existing phosphorus diffusion process is reduced and the process window is widened, and on the other hand, the passivation effect of the first surface 1a is improved.

In one or more embodiments, as shown in FIG. 1, the solar cell further includes an emitter 6, a second electrode 7, and a second passivation layer 8, where the emitter 6 is arranged on the second surface 1b. Along the thickness direction Z of the solar cell, a plurality of second electrodes 7 are arranged at a side of the emitter 6 away from the silicon substrate 1. The plurality of second electrodes 7 are respectively electrically connected to the emitter 6. The second passivation layer 8 covers the surface of the emitter 6 away from the silicon substrate 1. The emitter 6 has one or more Group III elements, such as boron (B), aluminum (Al), gallium (Ga), indium (In), etc. That is, the emitter 6 is a P-type emitter, which forms a PN junction with the N-type silicon substrate 1, reducing parasitic absorption of the incident light by the second surface 1b, improving the absorption rate of the incident light by the second surface 1b, and improving the injection efficiency of the photogenerated minority carriers, thereby facilitating improvement of the open-circuit voltage of the solar cell, increase of the short-circuit current of the solar cell, and further improvement of the photoelectric conversion efficiency of the solar cell.

A composition of the second passivation layer 8 includes one or more of silicon oxide, silicon nitride, titanium oxide, aluminum oxide, or silicon oxynitride. The second passivation layer 8 has a single-layer structure, or a multi-layer structure, and the refractive index and the thickness of each layer are correspondingly designed. The second passivation layer 8 has the similar function and effect to these of the first passivation layer 5, i.e., it plays a role in passivating the surface in contact therewith, which reduces the recombination of carriers at the interface and improves the transport efficiency of carriers, thereby improving the photoelectric conversion efficiency of the solar cell. The second passivation layer 8 also has functions of reducing or eliminating the reflection effect of the second surface 1b and increasing the light transmittance of the second surface 1b, which is beneficial for further improving the photoelectric conversion efficiency of the solar cell.

The second electrode 7 specifically serves as a positive electrode of the solar cell. At least part structure of the second electrode 7 penetrates through the second passivation layer 8 and forms electrical connection with the emitter 6. The emitter 6 is used for forming good ohmic contact between the second electrode 7 and the silicon substrate 1, facilitating reduction of the series resistance of the solar cells, and thereby facilitating improvement of the photoelectric conversion efficiency of the solar cell.

In addition, as shown in FIG. 1, the second surface 1b of the silicon substrate 1 is arranged as a pyramid texture structure, to reduce the reflectivity of the incident light by the second surface 1b, and increase the absorption and utilization of the light, thereby improving the light transmittance of the second surface 1b, and further improving the photoelectric conversion efficiency of the solar cell. The first surface 1a of the silicon substrate 1 is arranged as a non-pyramid texture structure, such as a stacked stepped morphology, allowing the antimony-containing tunneling oxide layer 2 on the first surface 1a to have relatively high density and uniformity, so that the antimony-containing tunneling oxide layer 2 has a good passivation on the silicon substrate 1.

The above descriptions are only preferred embodiments of the present disclosure and are not intended to limit the present disclosure, and various modifications and changes may be made by those skilled in the art. The scope of the present disclosure shall be defined by the appended claims.

## Claims

1. A solar cell, **characterized in that** the solar cell comprises:
a silicon substrate (1) containing antimony, wherein the silicon substrate (1) has a first surface (1a);
an antimony-containing tunneling oxide layer (2) covering the first surface (1a); and
a doped conductive layer (3) covering, along a thickness direction of the solar cell, a surface of the antimony-containing tunneling oxide layer (2) away from the silicon substrate (1), wherein the doped conductive layer (3) contains antimony,
wherein an antimony concentration of the antimony-containing tunneling oxide layer (2) is greater than an antimony concentration of the silicon substrate (1), and the antimony concentration of the silicon substrate (1) is greater than an antimony concentration of the doped conductive layer (3), and
wherein along the thickness direction of the solar cell, a first antimony-containing region (31) is formed at a side of the doped conductive layer (3) adjacent to the antimony-containing tunneling oxide layer (2), and an antimony concentration of the first antimony-containing region (31) is greater than an antimony concentration of rest region of the doped conductive layer (3).

2. The solar cell according to claim 1, **characterized in that** along the thickness direction of the solar cell, the antimony concentration of the antimony-containing tunneling oxide layer (2) gradually decreases in a direction away from the silicon substrate (1).

3. The solar cell according to claim 1, **characterized in that** along the thickness direction of the solar cell, the antimony concentration of the first antimony-containing region (31) gradually decreases in the direction away from the silicon substrate (1).

4. The solar cell according to claim 1, **characterized in that** the antimony concentration of the silicon substrate (1) ranges from 2.0×10¹⁶ cm⁻³ to 8.0×10¹⁶ cm⁻³.

5. The solar cell according to claim 1, **characterized in that** the antimony concentration of the antimony-containing tunneling oxide layer (2) ranges from 1.0×10¹⁸ cm⁻³ to 2.0×10¹⁸ cm⁻³.

6. The solar cell according to claim 1, **characterized in that** the antimony concentration of the first antimony-containing region (31) ranges from 1.0×10¹⁶ cm⁻³ to 1.0×10¹⁸ cm⁻³.

7. The solar cell according to claim 1, **characterized in that** a thickness of the first antimony-containing region (31) ranges from 5 nm to 10 nm.

8. The solar cell according to claim 1, **characterized in that** along the thickness direction of the solar cell, a second antimony-containing region (11) is formed at a side of the silicon substrate (1) adjacent to the antimony-containing tunneling oxide layer (2); and
along the thickness direction of the solar cell, an antimony concentration of the second antimony-containing region (11) gradually increases in a direction towards the antimony-containing tunneling oxide layer (2).

9. The solar cell according to claim 8, **characterized in that** a thickness of the second antimony-containing region (11) ranges from 5 nm to 10 nm.

10. The solar cell according to any one of claims 1 to 9, **characterized in that** a thickness of the antimony-containing tunneling oxide layer (2) ranges from 1 nm to 10 nm; and/or
a thickness of the doped conductive layer (3) ranges from 20 nm to 300 nm.

11. The solar cell according to any one of claims 1 to 8, **characterized in that** the doped conductive layer (3) further contains phosphorus, and a phosphorus concentration of the doped conductive layer (3) ranges from 1.0×10²⁰ cm⁻³ to 1.0×10²¹ cm⁻³.

12. The solar cell according to claim 1, **characterized in that** along the thickness direction of the solar cell, an antimony concentration at the side of the second antimony-containing region (11) away from the antimony-containing tunneling oxide layer (2) is lower than an antimony concentration at the side of the second antimony-containing region (11) adjacent to the antimony-containing tunneling oxide layer (2).

13. The solar cell according to claim 1, **characterized in that** the doped conductive layer (3) also contains antimony in rest region other than the first antimony-containing region (31), and wherein an antimony concentration of the rest region of the doped conductive layer (3) other than the first antimony-containing region (31) ranges from 1.0×10¹⁶ cm⁻³ to 2.0×10¹⁶ cm⁻3

14. The solar cell according to claim 11, **characterized in that** the silicon substrate (1) further contains phosphorus, and the phosphorus concentration of the doped conductive layer (3) is greater than a phosphorus concentration of the silicon substrate (1).

15. The solar cell according to claim 14, **characterized in that** a phosphorus concentration of the silicon substrate (1) ranges from 1.804×10¹⁵ cm⁻³ to 4.798×10¹⁶cm⁻³.
